# EUROPÄISCHE PATENTSCHRIFT

(11) **EP 4 143 929 B1**
(45) Veröffentlichungstag und Bekanntmachung des Hinweises auf die Patenterteilung: **11.06.2025**
(21) Anmeldenummer: 21722430.2
(22) Anmeldetag: 28.04.2021
(51) Int. Cl.: H01R 13/66, H01R 13/04, B60L 53/16

(54) **VORRICHTUNG ZUM ERFASSEN EINER TEMPERATUR EINES ELEKTRISCHEN KOPPLUNGSELEMENTS UND VERFAHREN**
DEVICE FOR DETECTING THE TEMPERATURE OF AN ELECTRIC COUPLING ELEMENT, AND METHOD
DISPOSITIF DE DÉTECTION DE LA TEMPÉRATURE D'UN ÉLÉMENT DE COUPLAGE ÉLECTRIQUE ET PROCÉDÉ

(30) Priorität: 29.04.2020 DE 102020111641
(43) Veröffentlichungstag der Anmeldung: 08.03.2023
(60) Teilanmeldung: 23196067.5
(73) Patentinhaber: Lisa Dräxlmaier GmbH, 84137 Vilsbiburg (DE)
(72) Erfinder: LIVK, Uros, 85748 Garching (DE); HECKELSMÜLLER, Stephan, 85386 Eching (DE); WENG, Thomas, Neufahrn 85375 (DE); SCHAFFERHANS, Stephan, München 81477 (DE)
(86) Internationale Anmeldenummer: PCT/EP2021/061042
(87) Internationale Veröffentlichungsnummer: WO 2021/219676

(56) Entgegenhaltungen:
- WO-A1-2018/197247
- DE-A1- 102015 106 251
- DE-A1- 102016 107 401
- DE-A1- 102019 114 229

## Beschreibung

### Technisches Gebiet

Die vorliegende Erfindung betrifft eine Vorrichtung zum Erfassen einer Temperatur eines elektrischen Kopplungselements. Des Weiteren betrifft die Erfindung ein Verfahren zum Erfassen einer Temperatur eines elektrischen Kopplungselements.

### Stand der Technik

Während einem elektrischen Ladevorgang eines Elektrofahrzeugs entsteht durch die Stromund Spannungsübertragung Wärmeenergie innerhalb eines elektrischen Koppelungselement, wie beispielsweise eine Ladebuchse und ein Ladestecker. Durch die entstehende Wärmeenergie während des Stromflusses können die Ladebuchse und der Ladestecker überhitzen. Um einen sicheren Betrieb des elektrischen Ladevorgangs zu gewährleisten, wird die Temperatur der strom- und spannungführenden Elemente der Ladebuchse und des Ladesteckers gemessen. Dies kann über einen Temperatursensor erfolgen, welcher über Kabel mit den strom- und spannungsführenden Elementen verbunden ist. Dies erfordert einen hohen Montageaufwand und einen langen Wärmeleitungsweg. Die Temperatur kann auch über Temperatursensoren gemessen werden, welche auf einer Leiterplatte befestigt sind.

Die DE 10 2019 114 229 A1 bezieht sich auf einen Ladestecker insbesondere für ein Elektrofahrzeug, wobei der Ladestecker eine Schaltung auf einer Leiterplatte, einen Komponententräger und zumindest ein quer zu der Leiterplatte ausgerichtetes Kontaktelement aufweist, wobei die Schaltung für das Kontaktelement einen Temperatursensor aufweist und der Komponententräger aus einem elektrisch isolierenden, wärmeleitenden Material besteht, wobei der Temperatursensor auf einer quer zu dem Kontaktelement ausgerichteten Vorderseite der Leiterplatte in einem Randbereich der Leiterplatte angeordnet ist und der Komponententräger als elektrischer Isolator und Wärmeleiter zwischen dem Kontaktelement und dem Temperatursensor angeordnet ist, wobei der Komponententräger zumindest im Bereich des Temperatursensors an dem Kontaktelement anliegt und der Temperatursensor in einer Vertiefung des Komponententrägers angeordnet ist.

Die DE 10 2016 401 A1 offenbart einen Steckvorrichtungseinsatz, welcher Kontaktelemente wie beispielsweise Kontaktstifte zur Leitung des elektrischen Stromes enthält. Die Kontaktelemente enthalten einen Kontaktbereich, in welchem sie komplementäre Kontaktelemente berühren, und einen Anschlussbereich, in welchem ein Leiter angeschlossen ist. Die Temperatur mindestens eines Kontaktelementes wird in einem Messbereich erfasst, der zwischen dem Kontaktbereich und dem Anschlussbereich liegt.

Die WO 2018/197247 A1 offenbart ein Steckverbinderteil zum Verbinden mit einem Gegensteckverbinderteil mit einem Gehäuseteil, einem am Gehäuseteil angeordneten elektrischen Kontaktelement zur Herstellung einer elektrische Kontaktierung mit dem Gegensteckverbinderteil und eine Temperaturüberwachungseinrichtung mit einer Sensoreinrichtung (56) zur Erkennung einer Erwärmung des Kontaktelements.

### Beschreibung der Erfindung

Eine Aufgabe der Erfindung ist es daher, unter Einsatz konstruktiv möglichst einfacher Mittel eine effiziente Temperaturmessung von elektrischen strom- und spannungsführenden Komponenten während einem elektrischen Ladevorgang durchzuführen.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Ein Aspekt der Erfindung betrifft eine Vorrichtung zum Erfassen einer Temperatur eines elektrischen Kopplungselements umfassend ein elektrisches Kontaktelement, das eingerichtet ist, elektrischen Strom zu einer elektrischen Komponente zu führen und einen Komponententräger, welcher an dem Kontaktelement angeordnet ist und der Komponententräger einen thermisch leitfähigen Bereich im unmittelbaren Kontakt mit dem Kontaktelement umfasst, wobei an dem Komponententräger eine Leiterplatte angeordnet ist, welche wenigstens einen Temperatursensor umfasst, der die Temperatur des Kontaktelements und damit des elektrischen Kopplungselements erfasst.

Das elektrische Kopplungselement kann eine Ladebuchse oder ein Ladestecker sein, welche für einen elektrischen Ladevorgang, insbesondere bei einem Elektrofahrzeug, benötigt werden. Um das Elektrofahrzeug elektrisch zu laden, wird das elektrische Kopplungselement, zum Beispiel der Ladebuchse, mit einem weiteren elektrischen Kopplungselement, zum Beispiel dem Ladestecker, gekoppelt. Das Kontaktelement ist zum Beispiel ein Hochvolt-Pin, welcher sich innerhalb des elektrischen Kopplungselement befindet. Das Kontaktelement kann insbesondere aus einem Metallmaterial bestehen. Das elektrische Kopplungselement kann mehrere Kontaktelemente aufweisen. Während einem elektrischen Laden fließen in dem Kontaktelement hohe elektrische Spannungen und Ladeströme.

Der Komponententräger ist an dem Kontaktelement angeordnet und umfasst im unmittelbaren Kontakt mit dem Kontaktelement einen thermisch leitfähigen Bereich. Der Komponententräger umfasst vorzugsweise eine Hartkomponente, beispielsweise ein Thermoplast, und den thermisch leitfähigen Bereich als Weichkomponente. Der thermisch leitfähige Bereich als Weichkomponente dient dem gerichteten Wärmetransport vom Kontaktelement zum Temperatursensor. Die Hartkomponente wird benötigt, um eine Montage mit hohem Automatisierungsgrad zu erleichtern. Zudem ist die Geometrie der Hartkomponente derart ausgeformt, dass die erforderlichen Mindestwerte für die Luft- und Kriechstrecken zwischen dem Kontaktelement und dem Temperatursensor übertroffen werden. Die Hartkomponente hat eine sehr geringe thermische Leitfähigkeit (z.B. 0,15 W/(m*K), sodass der Wärmestrom an die umgebende Luft und die angrenzenden Bauteile minimiert wird. Der Komponententräger kann mit dem Kontaktelement verschraubt werden. Der thermisch leitfähige Bereich dient zur galvanischen Trennung zwischen dem Kontaktelement und dem Temperatursensor. Der Wärmestrom des Kontaktelements wird über den thermisch leitfähigen Bereich zu dem Temperatursensor geleitet. Zum Beispiel kann ein Elastomer als der thermisch leitfähige Bereich ausgestaltet sein. Ebenso kann der thermisch leitfähige Bereich keramische oder mineralische Elemente aufweisen, welche eine höhere Wärmeleitfähigkeit des thermisch leitfähigen Bereichs erweisen. Zum Beispiel kann der thermisch leitfähige Bereich eine Wärmeleitfähigkeit von 1,5 W/(m*K) erreichen. Dabei ist jedoch zu beachten, dass ein zu hoher Füllgrad dazu führen kann, dass der Elastomer hart wird und sich weniger gut dem Kontaktelement und der Leiterplatte anschmiegt. Es muss also ein Kompromiss aus Wärmeleitfähigkeit und Härte für den thermisch leitfähigen Bereich getroffen werden.

Der Komponententräger kann einen weiteren Bereich umfassen, welcher aus einer Hartkomponente, beispielsweise einem Thermoplast, besteht. Dieser Bereich ist mechanisch beanspruchbar und dient der erleichterten Montage des Komponententrägers auf dem Kontaktelement. Je nach Fertigungs- und Montageverfahren können die mechanischen Anforderungen des Komponententrägers variieren. Zusätzlich erreicht der weitere Bereich nur eine geringe Wärmeleitfähigkeit, wodurch der Wärmestrom über den thermisch leitfähigen Bereich zu dem Temperatursensor leitet. Der Komponententräger ist so ausgeformt, dass er die Luft- und Kriechstrecken für die Hochvolt-Niedervolt-Trennung gewährleistet. Dafür ist ein Kragen vorgesehen, welcher parallel zur Oberfläche des Kontaktelements verläuft und diesen gegen die Leiterplatte elektrisch isoliert. Der Temperatursensor ist auf der dem Komponententräger abgewandten Seite der Leiterplatte platziert, um ihn vor mechanischer Beanspruchung zu schützen

Der Komponententräger kann auf einer Schulter des Kontaktelements anliegen. Die Schulter kann ein Vorsprung des Kontaktelements sein. Die Schulter kann ringförmig um das Kontaktelement umlaufen.

An dem Komponententräger ist die Leiterplatte angeordnet. Die Leiterplatte kann über Clipselemente an dem Komponententräger befestigt werden. Die Leiterplatte kann als PCB bezeichnet werden. An der Leiterplatte ist der Temperatursensor angeordnet, welcher möglichst unmittelbar zum thermisch leitfähigen Bereich und zum Kontaktelement angeordnet ist. Der Temperatursensor kann auf die Leiterplatte gelötet sein. Der Temperatursensor kann auf einem niedrigen Spannungsniveau, beispielsweise bis zu 12 Volt, betrieben werden. Durch die unmittelbare Anordnung des Temperatursensors an dem thermisch leitfähigen Bereich entsteht ein geringerer Wärmeverlust, welcher eine Genauigkeit der erfassten Werte des Temperatursensors gewährleistet.

Der Temperatursensor kann einen Wert einer Temperatur des elektrischen Kopplungselements erfassen und in einem elektrischen Signal abbilden. Der Temperatursensor ist dem Kontaktelement elektrisch isoliert und ist außerhalb eines Hochvoltbereichs des Kontaktelements angeordnet.

Die Vorrichtung kann ein Gehäuse umfassen, welches mehrteilig ausgebildet ist. Das Gehäuse kann aus einem elektrisch isolierenden Material bestehen. Das Gehäuse kann Aufnahmen für mehrere Kontaktelemente aufweisen. Das Kontaktelement kann in einem hinteren Gehäuseelement eingepresst werden. Zwischen dem hinteren Gehäuseelement und einem vorderen Gehäuseelement können der Komponententräger, die Leiterplatte und der Temperatursensor angeordnet sein, welche bei einem Zusammenbau des Gehäuses innerhalb des Gehäuses eingeschlossen werden. Das Gehäuses kann beispielsweise zusammengesteckt werden.

Eine elastische Dichtungsmatte kann zwischen einem vorderen Gehäuseelement und der Leiterplatte angeordnet sein. Die Dichtungsmatte kann im Bereich des Temperatursensors eine Nase aufweisen. Die Nase kann als Anschlagfläche für die Leiterplatte dienen.

Die Nase kann ebenfalls elastisch sein. Die Nase kann Bauteiltoleranzen ausgleichen. Das Kontaktelement kann in einem hinteren Gehäuseelement fixiert sein. Zum Beispiel kann das Kontaktelement in das hintere Gehäuseelement eingepresst werden. Das vordere Gehäuseelement und das hintere Gehäuseelement können miteinander verbunden werden, um den Komponententräger mit der Leiterplatte in einem Innenraum des Gehäuses einzuschließen.

Weiterhin ist die Leiterplatte unmittelbar an dem thermisch leitfähigen Bereich angeordnet. Um den Temperatursensor vor mechanischer Beanspruchung zu schützen, ist der Temperatursensor auf der dem thermisch leitfähigen Bereich abgewandten Seite der Leiterplatte angeordnet.

Ferner ist eine Wärmleitpaste zur Erhöhung der Wärmeleitfähigkeit zwischen Kontaktelement und Komponententräger und/oder zwischen Komponententräger und Leiterplatte einbringbar. Der Temperatursensor kann unter Verwendung des Wärmeleitmaterials thermisch mit der Leiterplatte und dem Komponententräger gekoppelt sein. Durch eine erhöhte Wärmeleitfähigkeit wird eine Genauigkeit der erfassten der Temperaturwerte gewährleistet.

In einer bevorzugten Ausführungsform umfasst die Leiterplatte wärmeleitende Elemente zur Erhöhung der Wärmeleitfähigkeit der Leiterplatte. Dabei können zum Beispiel in die Leiterplatte Kupferelemente als wärmeleitende Elemente in die Leiterplatte eingebettet sein. Hierfür sind gerade im Bereich des Temperatursensors Elemente mit hoher Wärmeleitfähigkeit in die Leiterplatte eingebettet, beispielsweise thermische Vias aus Kupfer. Die Leiterplatte kann die wärmeleitenden Elemente unmittelbar an dem Temperatursensor umfassen.

Weiterhin ist vorgesehen, dass an dem Komponententräger mindestens eine weitere Leiterplatte angeordnet ist, welche wenigstens einen weiteren Temperatursensor umfasst. Durch weitere Leiterplatten und Temperatursensoren kann die Temperatur des Kontaktelements an dem Kontaktelement an mehreren Messpunkten erfasst werden. Durch die Erfassung der Temperatur an mehreren Messpunkten des Kontaktelements können Temperaturabweichungen des Kontaktelements berücksichtigt werden. Zur Erfassung der Gesamttemperatur kann eine Mittelung der erfassten Werte erfolgen.

Die Erfindung betrifft weiterhin ein Verfahren zum Erfassen einer Temperatur eines elektrischen Kopplungselements, umfassend ein Bereitstellen eines elektrischen Kontaktelements, das eingerichtet ist, elektrischen Strom zu einer elektrischen Komponente zu führen, ein Anordnen eines Komponententrägers an dem Kontaktelement, wobei der Komponententräger einen thermisch leitfähigen Bereich im unmittelbaren Kontakt mit dem Kontaktelement umfasst und ein Anordnen der Leiterplatte an dem Komponententräger, welche wenigstens einen Temperatursensor umfasst, wobei durch den Temperatursensor die Temperatur des elektrischen Kopplungselements erfasst wird.

Die Temperatur wird auf der dem thermisch leitfähigen Bereich abgewandten Seite der Leiterplatte gemessen.

Ferner wird eine Wärmleitpaste zur Erhöhung der Wärmeleitfähigkeit zwischen Kontaktelement und Komponententräger und/oder zwischen Komponententräger und Leiterplatte eingebracht. Die Wärmeleitpaste kann elastisch, beziehungsweise plastisch verformbar sein.

In einer weiteren Ausführungsform umfasst das Anordnen des Komponententrägers an dem Kontaktelement ein Anspritzen mit einem Kunststoff an das Kontaktelement. Der Komponententräger kann somit als Spritzgussteil direkt an das Kontaktelement angespritzt werden. Dies ermöglicht einen hohen Automatisierungsgrad bei einem Zusammenbau des elektrischen Kopplungselements.

Weiterhin wird an dem Komponententräger mindestens eine weitere Leiterplatte angeordnet, welche wenigstens einen weiteren Temperatursensor umfasst.

### Kurze Figurenbeschreibung

Nachfolgend wird ein vorteilhaftes Ausführungsbeispiel der Erfindung unter Bezugnahme auf die begleitenden Figuren erläutert. Es zeigen:
- Figur 1: eine Schnittdarstellung durch das elektrische Kontaktelement gemäß einem ersten Ausführungsbeispiel,
- Figur 2: eine Schnittdarstellung durch das elektrische Kontaktelement gemäß einem zweiten Ausführungsbeispiel und
- Figur 3: eine Schnittdarstellung durch das elektrische Kontaktelement gemäß einem dritten Ausführungsbeispiel.

Die Figuren sind lediglich schematische Darstellungen und dienen nur der Erläuterung der Erfindung. Gleiche oder gleichwirkende Elemente sind durchgängig mit den gleichen Bezugszeichen versehen.

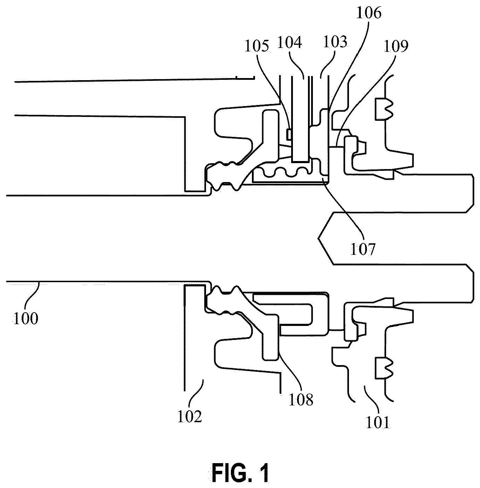

Die Fig. 1 zeigt eine Schnittdarstellung durch das elektrische Kontaktelement 100 gemäß einem ersten Ausführungsbeispiel.

Das elektrische Kontaktelement 100 ist Teil eines elektrischen Kopplungselements. Beispielsweise kann das elektrische Kopplungselement ein Ladestecker oder eine Ladebuchse, insbesondere für ein Elektrofahrzeug sein. In dem ersten Ausführungsbeispiel ist das elektrische Kontaktelement 100 ein Pin 100. Der Pin 100 ist in einem hinteren Gehäuseelement 101 eines zweiteiligen Gehäuses eingesetzt und mechanisch mit dem hinteren Gehäuseelement 101 verbunden. Das hintere Gehäuseelement 101 kann mit einem vorderen Gehäuseelement 102 beispielsweise über Verschrauben, Clipsen oder Verschweißen miteinander verbunden werden. Zwischen dem hinteren Gehäuseelement 101 und einem vorderen Gehäuseelement 102 sind ein Komponententräger 103 und eine Leiterplatte 104 angeordnet.

Die Leiterplatte 104 liegt an dem Komponententräger 103 an und ist an dem Komponententräger 103 befestigt. Die Leiterplatte 104 umfasst an einer des Komponententrägers 103 gegenüberliegenden Seite der Leiterplatte 104 einen Temperatursensor 105. Der Temperatursensor 105 dient zur Erfassung der Temperatur der elektronischen Komponente, insbesondere des Pins 100.

Weiterhin umfasst der Komponententräger 103 einen thermisch leitfähigen Bereich 106. Der Temperatursensor 105 ist so nahe wie möglich an einer Kontaktstelle zwischen dem Pin 100 und dem thermisch leitfähigen Bereich 106 angeordnet. Der thermisch leitfähige Bereich 106 kann aus einem thermisch leitfähigen Elastomer bestehen. Ein Wärmestrom des Pins 100 leitet somit über den thermisch leitfähigen Bereich 106 des Komponententrägers 103 über die Leiterplatte 104 zu dem Temperatursensor 105. Zur Erhöhung der Wärmeleitfähigkeit der Leiterplatte 104, kann die Leiterplatte 104 in einem Bereich des Temperatursensors 105 wärmeleitende Elemente aufweisen.

Der Komponententräger 103 isoliert den Temperatursensor 105 von der im Betrieb an dem Pin 100 anliegenden Hochvoltspannung. Der Komponententräger 103 umfasst neben dem thermisch leitfähigen Bereich 106 einen Hartkomponentenbereich 107, welcher eine geringe Wärmeleitfähigkeit aufweist. Der Hartkomponentenbereich 107 kann zum Beispiel eine Wärmeleitfähigkeit von 0,15 W/(m*K) aufweisen. Zusätzlich ist der Hartkomponentenbereich 107 mechanisch beanspruchbar.

Der Komponententräger 103 ist auf einem Vorsprung 109 des Kontaktelements 100 so anzuordnen, dass der thermisch leitfähige Bereich 106 direkt auf dem Vorsprung 109 des Kontaktelements 100 anliegt. Dadurch leitet der Wärmestrom direkt von dem Kontaktelement 100 über den thermisch leitfähigen Bereich 106 zu dem Temperatursensor 105.

An dem Pin 100 ist eine elastische Dichtungsmatte 108 angeordnet, welche den Pin 100 zum Beispiel fluiddicht abdichtet. Die Dichtungsmatte 108 ist in dem vorderen Gehäuseelement 102 eingesetzt.

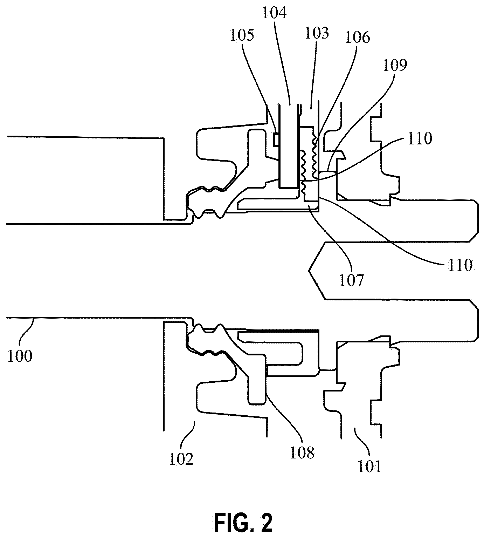

Die Fig. 2 zeigt eine Schnittdarstellung durch das elektrische Kontaktelement 100 gemäß einem zweiten Ausführungsbeispiel.

Gemäß dem zweiten Ausführungsbeispiel besteht der Hartkomponentenbereich 107 aus einem Thermoplast. Der thermisch leitfähige Bereich 106 besteht aus Keramik. Das Keramik weist mit dem Thermoplast strukturmechanische Eigenschaften auf, sodass die mechanische Beanspruchbarkeit und die thermische Leitfähigkeit gewährleistet wird. Zwischen dem Pin 100 und dem Komponententräger 103, sowie zwischen dem Komponententräger 103 und der Leiterplatte 104 ist eine Wärmeleitpaste 110 aufgetragen. Gemäß einem weiteren Ausführungsbeispiel ist die Wärmeleitpaste 110 zwischen dem Komponententräger 103 und der Leiterplatte 104 oder zwischen dem Pin 100 und dem Komponententräger 103 aufgetragen.

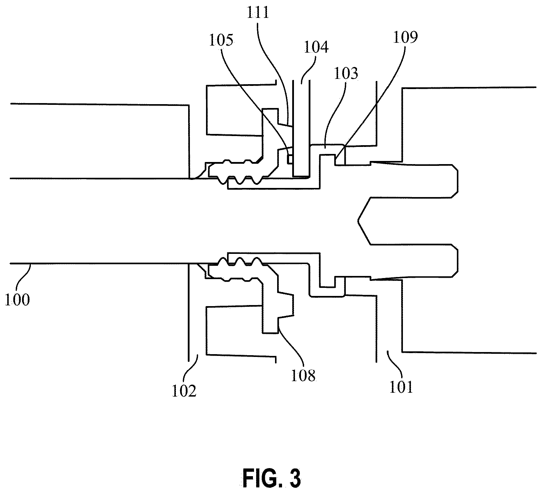

Die Fig. 3 zeigt eine Schnittdarstellung durch das elektrische Kontaktelement 100 gemäß einem dritten Ausführungsbeispiel.

Gemäß dem dritten Ausführungsbeispiel ist der Komponententräger 103 um den Pin 100 umspritzt. Der Komponententräger 103 besteht dabei aus einem Kunststoff, insbesondere aus einem Elastomer. Das Elastomer wird in einem Bereich zwischen dem vorderen Gehäuseelement 102 und dem hinteren Gehäuseelement 101 an einem Vorsprung 109 des Pins 100 angespritzt. Die Leiterplatte 104 liegt direkt an dem Komponententräger 103 an und ist zum Beispiel über Clipselemente an dem Komponententräger 103 befestigt. Die elastische Dichtungsmatte 108 umfasst an der zum Temperatursensor 105 gewandten Seite eine Nase 111. Die Nase 111 liegt an der des Temperatursensors 105 angeordneten Fläche der Leiterplatte 104 an und schützt den Temperatursensor 105 vor mechanischen Beanspruchungen, insbesondere beim Zusammenfügen des vorderen Gehäuseelements 102 mit dem hinteren Gehäuseelement 101. Weiterhin kann die Nase 111 Bauteiltoleranzen ausgleichen. Die Nase 111 kann ebenfalls elastisch sein.

Zur Montage wird der Pin 100 in das hintere Gehäuseelement 101 fixiert. Beispielsweise kann der Pin 100 in das hintere Gehäuseelement 101 eingepresst werden. Auf den Komponententräger 103 kann Wärmeleitpaste 110 aufgetragen werden. Alternativ kann die Wärmeleitpaste 110 auch auf das Kontaktelement 100 aufgetragen werden. Anschließend wird die Leiterplatte 104 an der mit Wärmeleitpaste 110 aufgetragenen Fläche des Komponententrägers 103 befestigt. An dem vorderen Gehäuseelement 102 wird die Dichtungsmatte 108 angeordnet. Das vordere Gehäuseelement 102 wird über den Pin 100 geschoben und damit gleichzeitig der Komponententräger 103 mit der Leiterplatte 104 gegen den Pin 100 gepresst.

Der hier vorgestellte Ansatz weist eine kostengünstige und einfache Architektur auf. Durch die thermische Kopplung des Temperatursensors mit dem Kontaktelement über die Leiterplatte und den thermisch leitfähigen Bereich des Komponententrägers wird die Temperaturerfassung vereinfacht und es kann eine erhöhte Messgenauigkeit sichergestellt werden. Der Komponententräger kann als ein Spritzgussteil aus Kunststoff hergestellt werden und direkt an das Kontaktelement angespritzt werden. Der Zusammenbau des elektrischen Kopplungselement kann durch eine Steckmontage automatisiert erfolgen.

### BEZUGSZEICHENLISTE

- 100: Kontaktelement
- 101: hinteres Gehäuseelement
- 102: vorderes Gehäuseelement
- 103: Komponententräger
- 104: Leiterplatte
- 105: Temperatursensor
- 106: thermisch leitfähiger Bereich
- 107: Hartkomponentenbereich
- 108: Dichtungsmatte
- 109: Vorsprung
- 110: Wärmeleitpaste
- 111: Nase

## Patentansprüche

1. Vorrichtung zum Erfassen einer Temperatur eines elektrischen Kopplungselements umfassend
ein elektrisches Kontaktelement (100), das eingerichtet ist, elektrischen Strom zu einer elektrischen Komponente zu führen;
einen Komponententräger (103), welcher an dem Kontaktelement (100) anordbar ist und der Komponententräger (103) einen thermisch leitfähigen Bereich (106) im unmittelbaren Kontakt mit dem Kontaktelement (100) umfasst, wobei an dem Komponententräger (103) eine Leiterplatte (104) angeordnet ist, welche wenigstens einen Temperatursensor (105) umfasst, der die Temperatur des Kontaktelements (100) und damit des elektrischen Kopplungselements erfasst, **dadurch gekennzeichnet, dass** die Leiterplatte (104) unmittelbar an dem thermisch leitfähigen Bereich (106) angeordnet ist und der Temperatursensor (105) auf der dem thermisch leitfähigen Bereich (106) abgewandten Seite der Leiterplatte (104) angeordnet ist.

2. Vorrichtung nach Anspruch 1, **dadurch gekennzeichnet, dass** eine Wärmleitpaste (110) zur Erhöhung der Wärmeleitfähigkeit zwischen Kontaktelement (100) und Komponententräger (103) und/oder zwischen Komponententräger (103) und Leiterplatte (104) einbringbar ist.

3. Vorrichtung nach einem der vorstehenden Ansprüche, wobei die Leiterplatte (104) wärmeleitende Elemente zur Erhöhung der Wärmeleitfähigkeit der Leiterplatte (104) umfasst.

4. Vorrichtung nach einem der vorstehenden Ansprüche, **dadurch gekennzeichnet, dass** an dem Komponententräger (103) mindestens eine weitere Leiterplatte (104) angeordnet ist, welche wenigstens einen weiteren Temperatursensor (105) umfasst.

5. Verfahren zum Erfassen einer Temperatur eines elektrischen Kopplungselements, umfassend
Bereitstellen eines elektrischen Kontaktelements (100), das eingerichtet ist, elektrischen Strom zu einer elektrischen Komponente zu führen,
Anordnen eines Komponententrägers (103) an dem Kontaktelement (100), wobei der Komponententräger (103) einen thermisch leitfähigen Bereich (106) im unmittelbaren Kontakt mit dem Kontaktelement (100) umfasst, und
Anordnen der Leiterplatte (104) an dem Komponententräger (103), welche wenigstens einen Temperatursensor (105) umfasst, **dadurch gekennzeichnet, dass** die Leiterplatte (104) unmittelbar an dem thermisch leitfähigen Bereich (106) angeordnet wird und der Temperatursensor (105) auf der dem thermisch leitfähigen Bereich (106) abgewandten Seite der Leiterplatte (104) angeordnet wird und wobei durch den Temperatursensor (105) die Temperatur des Kontaktelements (100) und damit des elektrischen Kopplungselements erfasst wird.

6. Verfahren nach Anspruch 5, **dadurch gekennzeichnet, dass** die Temperatur auf der dem thermisch leitfähigen Bereich (106) abgewandten Seite der Leiterplatte (104) gemessen wird.

7. Verfahren nach einem der Ansprüche 5 oder 6, **dadurch gekennzeichnet, dass** eine Wärmleitpaste (110) zur Erhöhung der Wärmeleitfähigkeit zwischen Kontaktelement (100) und Komponententräger (103) und/oder zwischen Komponententräger (103) und Leiterplatte (104) eingebracht wird.

8. Verfahren nach einem der Ansprüche 5 bis 7, wobei das Anordnen des Komponententrägers (103) an dem Kontaktelement (100) ein Anspritzen mit einem Kunststoff an das Kontaktelement (100) umfasst.

9. Verfahren nach einem der Ansprüche 5 bis 8, **dadurch gekennzeichnet, dass** an dem Komponententräger (103) mindestens eine weitere Leiterplatte (104) angeordnet wird, welche wenigstens einen weiteren Temperatursensor (105) umfasst.

## Claims

1. Device for detecting a temperature of an electrical coupling element, comprising
an electrical contact element (100) which is designed to conduct electric current to an electrical component;
a component support (103) which can be arranged on the contact element (100) and the component support (103) comprises a thermally conductive region (106) in direct contact with the contact element (100), wherein a printed circuit board (104) is arranged on the component support (103), which printed circuit board comprises at least one temperature sensor (105) which detects the temperature of the contact element (100) and thus of the electrical coupling element, **characterized in that**
the printed circuit board (104) is arranged directly on the thermally conductive region (106) and the temperature sensor (105) is arranged on that side of the printed circuit board (104) which is averted from the thermally conductive region (106).

2. Device according to Claim 1, **characterized in that** a thermally conductive paste (110) can be introduced between the contact element (100) and the component support (103) and/or between the component support (103) and the printed circuit board (104) for the purpose of increasing the thermal conductivity.

3. Device according to either of the preceding claims, wherein the printed circuit board (104) comprises thermally conductive elements for the purpose of increasing the thermal conductivity of the printed circuit board (104).

4. Device according to any of the preceding claims, **characterized in that** at least one further printed circuit board (104) is arranged on the component support (103), which further printed circuit board comprises at least one further temperature sensor (105).

5. Method for detecting a temperature of an electrical coupling element, comprising
providing an electrical contact element (100), which is designed to conduct electric current to an electrical component,
arranging a component support (103) on the contact element (100), wherein the component support (103) comprises a thermally conductive region (106) in direct contact with the contact element (100), and
arranging the printed circuit board (104) on the component support (103), which printed circuit board comprises at least one temperature sensor (105), **characterized in that**
the printed circuit board (104) is arranged directly on the thermally conductive region (106) and the temperature sensor (105) is arranged on that side of the printed circuit board (104) which is averted from the thermally conductive region (106) and wherein the temperature of the contact element (100) and thus of the electrical coupling element is detected by the temperature sensor (105).

6. Method according to Claim 5, **characterized in that** the temperature is measured on that side of the printed circuit board (104) which is averted from the thermally conductive region (106).

7. Method according to either of Claims 5 and 6, **characterized in that** a thermally conductive paste (110) is introduced between the contact element (100) and the component support (103) and/or between the component support (103) and the printed circuit board (104) for the purpose of increasing the thermal conductivity.

8. Method according to any of Claims 5 to 7, wherein arranging the component support (103) on the contact element (100) comprises injection moulding onto the contact element (100) using a plastic.

9. Method according to any of Claims 5 to 8, **characterized in that** at least one further printed circuit board (104) is arranged on the component support (103), which further printed circuit board comprises at least one further temperature sensor (105).

## Revendications

1. Dispositif de détection de la température d'un élément de couplage électrique, comprenant
un élément de contact électrique (100) qui est conçu pour délivrer un courant électrique à un composant électrique ;
un support de composant (103) qui peut être agencé sur l'élément de contact (100) et le support de composant (103) comprenant une région thermoconductrice (106) en contact direct avec l'élément de contact (100), le support de composant (103) étant doté d'une carte de circuit imprimé (104) qui comprend au moins un capteur de température (105) qui détecte la température de l'élément de contact (100) et donc de l'élément de couplage électrique, **caractérisé en ce que**
la carte de circuit imprimé (104) est agencée directement sur la région thermoconductrice (106) et le capteur de température (105) est agencé sur le côté de la carte de circuit imprimé (104) qui est opposé à la région thermoconductrice (106).

2. Dispositif selon la revendication 1, **caractérisé en ce qu'**une pâte thermoconductrice (110) peut être introduite pour augmenter la conductivité thermique entre l'élément de contact (100) et le support de composant (103) et/ou entre le support de composant (103) et la carte de circuit imprimé (104).

3. Dispositif selon l'une quelconque des revendications précédentes, dans lequel la carte de circuit imprimé (104) comprend des éléments thermoconducteurs destinés à augmenter la conductivité thermique de la carte de circuit imprimé (104).

4. Dispositif selon l'une quelconque des revendications précédentes, **caractérisé en ce que** le support de composant (103) est doté d'au moins une autre carte de circuit imprimé (104) qui comprend au moins un autre capteur de température (105).

5. Procédé de détection de la température d'un élément de couplage électrique, comprenant
la fourniture d'un élément de contact électrique (100) qui est conçu pour délivrer un courant électrique à un composant électrique,
l'agencement d'un support de composant (103) sur l'élément de contact (100), le support de composant (103) comprenant une région thermoconductrice (106) en contact direct avec l'élément de contact (100), et
l'agencement de la carte de circuit imprimé (104) sur le support de composant (103), qui comprend au moins un capteur de température (105), **caractérisé en ce que**
la carte de circuit imprimé (104) est agencée directement sur la région thermoconductrice (106) et le capteur de température (105) est agencé sur le côté de la carte de circuit imprimé (104) qui est opposé à la région thermoconductrice (106) et la température de l'élément de contact (100) et donc de l'élément de couplage électrique étant détectée par le capteur de température (105).

6. Procédé selon la revendication 5, **caractérisé en ce que** la température est mesurée sur le côté de la carte de circuit imprimé (104) qui est opposé à la région thermoconductrice (106).

7. Procédé selon l'une quelconque des revendications 5 ou 6, **caractérisé en ce qu'**une pâte thermoconductrice (110) est introduite entre l'élément de contact (100) et le support de composant (103) et/ou entre le support de composant (103) et la carte de circuit imprimé (104) pour augmenter la conductivité thermique.

8. Procédé selon l'une quelconque des revendications 5 à 7, dans lequel l'agencement du support de composant (103) sur l'élément de contact (100) comprend un surmoulage par injection d'une matière plastique sur l'élément de contact (100).

9. Procédé selon l'une quelconque des revendications 5 à 8, **caractérisé en ce que** le support de composant (103) est doté d'au moins une autre carte de circuit imprimé (104) qui comprend au moins un autre capteur de température (105).
